# EUROPEAN PATENT SPECIFICATION

(11) **EP 3 410 510 B1**
(45) Date of publication and mention of the grant of the patent: **20.10.2021**
(21) Application number: 17000963.3
(22) Date of filing: 02.06.2017
(51) Int. Cl.: H01L 51/54, H01L 51/52

(54) **ORGANIC ELECTRONIC DEVICE AND METHOD FOR PRODUCING THE ORGANIC ELECTRONIC DEVICE**
ORGANISCHE ELEKTRONISCHE VORRICHTUNG UND VERFAHREN ZUR HERSTELLUNG DER ORGANISCHEN ELEKTRONISCHEN VORRICHTUNG
DISPOSITIF ÉLECTRONIQUE ORGANIQUE ET PROCÉDÉ DE FABRICATION ASSOCIÉ

(43) Date of publication of application: 05.12.2018
(73) Proprietor: Novaled GmbH, 01099 Dresden (DE)
(72) Inventor: Rosenow, Thomas, 01307 Dresden (DE); Hummert, Markus, 01307 Dresden (DE); Canzler, Tobias, 01307 Dresden (DE)
(74) Representative: Bittner, Thomas L.

(56) References cited:
- US-A1- 2011 156 019
- US-A1- 2016 005 991
- FENGYING LI ET AL: "Photoconductivity of [60]fullerene derivative doped PVK", SOLID STATE COMMUNICATIONS, vol. 107, no. 4, 1 January 1998 (1998-01-01), pages 189-192, XP055120493, ISSN: 0038-1098, DOI: 10.1016/S0038-1098(98)00187-2

## Description

The present disclosure refers to an organic electronic device, and a method for producing the organic electronic device.

### Background

Organic electronic devices may be provided with a charge generation layer which may also be referred to as pn-junction. Such charge generation layer may be provided as part of a tandem device which comprises at least two light emitting layers, thereby forming a tandem organic light emitting device (tandem OLED). The charge generation layer comprises, a n-type sub-layer comprising a redox n-dopant, and a p-type sub-layer, comprising a p-dopant. Charge generation layers comprising known state-of-art organic p-dopants, e.g. quinoid compounds or radialene compounds, are known.

WO 2010 / 029542 A1 relates to methods for producing p-doped organic semiconductor material with a fullerene derivative having at least one electron-withdrawing substituent covalently attached thereto, and semiconductor compositions prepared thereby are provided. Also provided are electronic devices, such as transistors, solar-cells, illuminating devices, OLEDs and detectors, comprised of these p-doped organic semiconductor materials.

Document US 2016 / 005991 A1 discloses an organic light-emitting device with a first organic light-emitting layer and a second organic light-emitting layer. A first charge generation layer (CGL) is disposed between the first organic light-emitting layer and the second organic light-emitting layer and a second CGL disposed between the first CGL and the second organic light-emitting layer. Further, a buffer layer including fullerene is disposed between the first CGL and the second CGL.

Document US 2011 / 156019 A1 pertains to methods for producing p-doped organic semiconductor material with a fullerene derivative having at least one covalently attached electron-withdrawing substituent. Semiconductor compositions correspondingly prepared are provided, as well as electronic devices such as transistors, solar-cells, illuminating devices, OLEDs and detectors.

There remains a need to improve the performance organic electronic devices comprising a charge generation layer, in particular of organic light emitting devices.

### Summary

It is an object of the present disclosure to provide an organic electronic device having an improved performance, in particular operating voltage, the organic electronic device comprising a charge generation layer.

For solving the problem, an organic electronic device and a method for producing an organic electronic device according to the independent claims 1 and 13 respectively, are provided. Alternative embodiments are disclosed in dependent claims.

According to an aspect, an organic electronic device is provided, comprising a first electrode; a second electrode; and a charge generation layer arranged between the first and the second electrode. The charge generation layer comprises a n-type sub-layer comprising at least one redox n-dopant, and a p-type sub-layer comprising a fullerene compound, wherein the fullerene compound comprises at least one electron withdrawing substituent selected from F, CI, Br, I, CN, halogen-substituted and / or CN-substituted group containing 1 to 20 carbon atoms.

According to a further aspect, a method for producing an organic electronic device is provided, the method comprising providing a substrate, and producing a stack of layers on the substrate, the stack of layers comprising a first electrode; a second electrode; and a charge generation layer arranged between the first and the second electrode. The charge generation layer is comprising a n-type sub-layer comprising at least one redox n-dopant, and a p-type sub-layer comprising a fullerene compound, wherein the fullerene compound comprises at least one electron withdrawing substituent selected from F, Cl, Br, I, CN, halogen-substituted and / or CN-substituted group containing 1 to 20 carbon atoms. The method further comprises the steps of providing the substrate and the first electrode, depositing a plurality of layers arranged on the first electrode, the plurality of layers comprising the charge generation layer, and depositing the second electrode on the plurality of layers.

According to another embodiment, one or more organic electronic devices may form a display device or lighting device.

The at least one redox n-dopant may by an elemental metal. In one embodiment, the at least one redox n-dopant may by an electropositive metal selected from alkali metals, alkaline earth metals, and rare earth metals. In an alternative embodiment, the at least one redox n-dopant may by selected from Li, Na, K, Rb, Cs, Mg, Ca, Sr, Ba, Eu and Yb. In another alternative embodiment, the at least one redox n-dopant may by selected from Li, Na, Mg, Ca, Sr and Yb. In still another alternative embodiment, the at least one redox n-dopant may by selected from Li and Yb.

According to another embodiment, the fullerene compound comprising at least one electron withdrawing substituent may be a p-dopant.

The fullerene compound may comprise at least two electron withdrawing substituents independently selected from F, Cl, Br, I, CN, halogen-substituted and / or CN-substituted group containing 1 to 20 carbon atoms, preferably from F, CN, halogen-substituted and / or CN-substituted group containing 1 to 6 carbon atoms, more preferred from F, CN or halogen-substituted group containing 1 to 4 carbon atoms. The fullerene compound may comprise at least two electron withdrawing substituents, wherein each electron withdrawing substituent is independently selected from F and CN. For example, in case of only two substituents, possible combinations thereof, such as F+F, F+CN, CN+CN, may be provided.

The fullerene compound may have formula CₓF_{y}, wherein x is an integer from 60 to 120 and F is an integer equal or higher than x / 2.

In one embodiment, the fullerene compound may have formula C₆₀F₃₆, C₆₀F₄₈ or C₇₀F₅₄, preferably the fullerene compound is selected from C₆₀F₄₈.

According to another embodiment, the organic electronic device further comprises at least one, preferably two emitting layers. The charge generation layer may be arranged between the first emitting layer and the second emitting layer.

According to another embodiment, the charge generation layer is in direct contact with the first and / or second electrode. In general, with regard to the present application, the wording direct contact refers to a touch contact.

The charge generation layer is provided with the following: the n-type sub-layer comprises at least one electron transport matrix compound; and the p-type sub-layer comprises at least one hole transport matrix compound.

The at least one hole transport matrix compound may be an organic compound. The at least one hole transport matrix compound may be an organic compound comprising a conjugated system of at least 6, alternatively at least 10 delocalized electrons. In an alternative embodiment, the at least one hole transport matrix compound may comprise at least one triaryl amine structural moiety. In another alternative embodiment, the at least one hole transport matrix compound may comprise at least two triaryl amine structural moieties.

The at least one electron transport matrix compound may be an organic compound. The at least one electron transport matrix compound may comprise a conjugated system of at least 6, alternatively at least 10 delocalized electrons. In an alternative embodiment, the at least one electron transport matrix compound may comprise at least two aromatic or heteroaromatic rings which are either linked by a covalent bond or condensed. In another embodiment, the at least one electron transport matrix compound may comprise at least one phenanthroline structural moiety and / or at least one phosphine oxide structural moiety. Preferably, the electron transport matrix compound comprises at least two phenathroline structural moieties.

Suitable electron matrix compounds are disclosed in EP 2 833 429 A1, WO 2011 / 154131 A1 and WO 17 / 089399 A1.

The n-type sub-layer may comprise a first n-type sub-layer arranged closer to the first electrode, and a second n-type sub-layer arranged closer to the second electrode. Further, the at least one redox n-dopant may be provided with a higher concentration in the second n-type sub-layer than in the first n-type sub-layer. The first and the second n-type sub-layers may be provided adjacent to each other, thereby providing direct contact between the first and the second n-type sub-layers. The first and the second n-type sub-layers of the n-type sub-layer may be provided with different concentration of the at least one redox n-dopant. For the at least one redox n-dopant, a dopant concentration gradient may be provided over the first and second n-type sub-layers, whereby the concentration of redox n-dopant is higher in the layer or section of the layer closer to the second electrode and lower in the layer or section of the layer closer to the first electrode.

In another embodiment, the n-type sub-layer may further comprise a metal selected from alkali, alkaline earth or rare earth metal, wherein the concentration of the metal is higher in the section closer to the second electrode and lower in the section closer to the first electrode. Preferably, the metal is selected from alkali metal, more preferred from Li.

An interlayer may be provided between the n-type sub-layer and the p-type sub-layer in the charge generation layer. One or both layers may be in direct contact with the interlayer. The interlayer may comprise or consist of metal.

In another embodiment, the interlayer comprises or consists of the redox n-dopant. Preferably, the redox n-dopant in the n-type sublayer and the interlayer are selected the same. According to another embodiment, the interlayer comprises or consists of Li, Al or Yb.

For the organic electronic device the following may be provided: the first electrode is provided as an anode; a second electrode is provided as a cathode; the n-type sub-layer is arranged closer to the first electrode; and the p-type sub-layer is arranged closer to the second electrode.

The organic electronic device may comprise at least one first light emitting layer arranged between the first electrode and the n-type sub-layer, and at least one second light emitting layer arranged between the p-type sub-layer and the second electrode. In an embodiment, the organic electronic device is a tandem organic light emitting device. With regard to the tandem organic light emitting device, the alternative embodiments outlined above may be applied mutatis mutandis.

At least one of the at least one first light emitting layer or the at least one second light emitting layer may comprise a blue emitter. The blue emitter may be a blue fluorescent emitter. Preferably, the organic electronic device comprises one light emitting layer comprising a blue emitter and at least one light emitting layer comprising a yellow emitter.

An exemplary tandem OLED may consist of the following layers: an indium tin oxide (ITO) anode, a first (redox p-doped) hole injection layer, a first (undoped) hole transport layer, a first (undoped) electron blocking layer, a first emitting layer comprising a fluorescent blue emitter, a first electron transport layer (optionally comprising an electrical n-dopant) in contact with the n-CGL, a second (redox p-doped) hole injection layer in contact with the p-CGL, a second (undoped) hole transport layer, a second (undoped) electron blocking layer, a second emitting layer comprising a fluorescent blue emitter, a second electron transport layer (optionally comprising an electrical n-dopant) in contact with the cathode. Further charge injection or blocking layers may be added or omitted.

With regard to the method for producing the organic electronic device, the alternative embodiments outlined above may be applied *mutatis mutandis.* For example, the charge generation layer may be produced with an interlayer provided between the n-type sub-layer, and the p-type sub-layer.

The stack of layers may be produced by techniques known in the art as such. For example, one or more layers in the stack may be produced by vacuum thermal evaporation.

With regard to the method of producing the organic electronic device, the depositing of the plurality of layers may comprise a step of depositing the p-type sub-layer, the depositing comprising evaporation and deposition of the fullerene compound in vacuum. Preferably, all layers are deposited in vacuum. In the context of the present invention, vacuum means a pressure of less than 10⁻³ mbar.

### Description of embodiments

Following, further embodiments are described by referring to figures.
- Fig. 1: is a schematic representation of a layer stack of a tandem organic light emitting device;
- Fig. 2: is a schematic representation of a layer stack of another a tandem organic light emitting device;
- Fig. 3: is a schematic representation of a layer stack of a further a tandem organic light emitting device;
- Fig. 4: is a graphical representation of current density in dependence on a voltage applied for a tandem organic light emitting device according to Example 1, for the tandem device comprising as the p-dopant in the p-CGL compound PD-3, in comparison with the device comprising a state-of-art p-dopant PD-1 (see Table 1);
- Fig. 5: is a graphical representation of current density in dependence on a voltage applied for a tandem organic light emitting device according to Example 2, for the tandem device comprising as the p-dopant in the p-CGL compound PD-3, in comparison with the device comprising a state-of-art p-dopant PD-1 (see Table 2);
- Fig. 6: is a graphical representation of quantum efficiency in dependence on current density for the tandem organic light emitting devices according to description for Fig. 5;
- Fig. 7: is a graphical representation of current density in dependence on a voltage applied for a tandem organic light emitting device according to Example 3, for the tandem device comprising as the p-dopant in the p-CGL compound PD-3, in comparison with the device comprising a state-of-art p-dopant PD-1 (see Table 3); and
- Fig. 8: is a graphical representation of quantum efficiency in dependence on current density for the tandem organic light emitting devices according to description for Fig. 7.

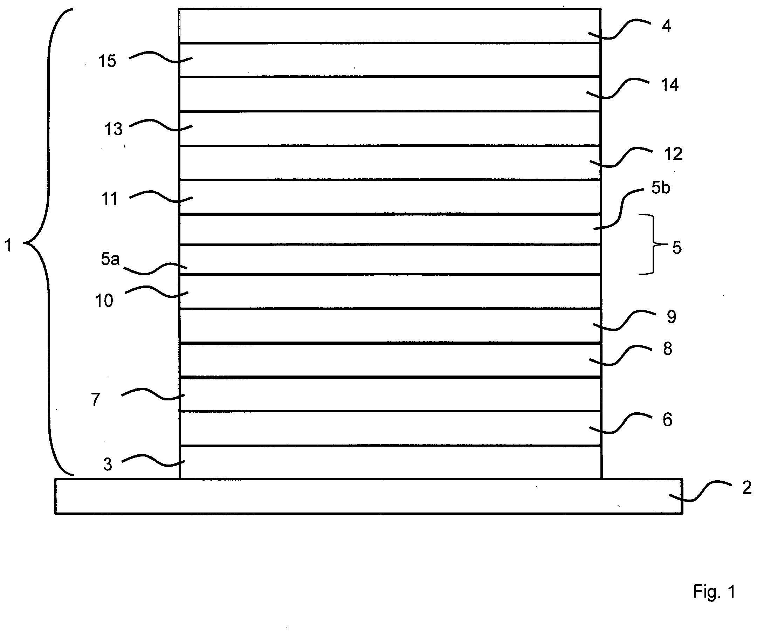

Fig. 1 shows a schematic representation of a tandem organic light emitting device (tandem OLED). A stack of layers 1 provided on a substrate 2 comprises a first electrode 3, and a second electrode 4 provided as an anode and a cathode, respectively, in the embodiment depicted.

There is a charge generation layer, also named CGL, 5 provided comprising a n-type sub-layer 5a, and a p-type sub-layer 5b.

A first hole injection layer 6, a first hole transport layer 7, and a first electron blocking layer 8 are provided between the anode 3 and a first emitting layer 9. A first electron transport layer 10 is provided between the first emitting layer 9 and the charge generation layer 5. A second hole injection layer 11, second hole transport layer 12, and second electron blocking layer 13 are provided between the charge generation layer 5 and a second emitting layer 14. A second electron transport layer 15 is provided between the second emitting layer 14 and the cathode 4.

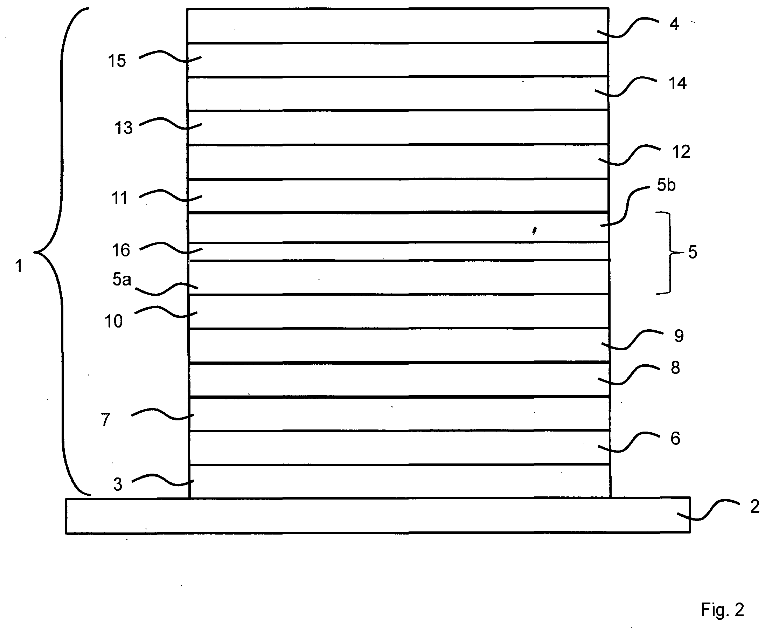

Fig. 2 shows a schematic representation of another tandem OLED. The stack of layers 1 provided on the substrate 2, in addition, comprises an interlayer 16.

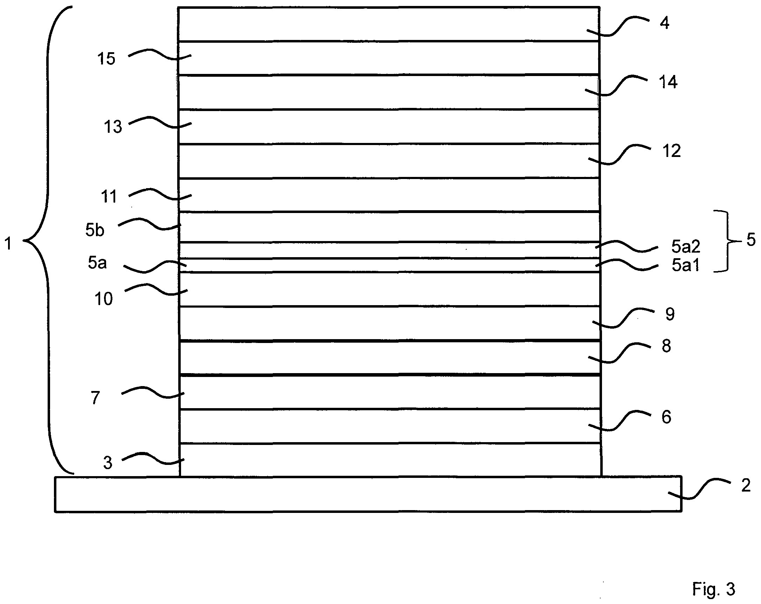

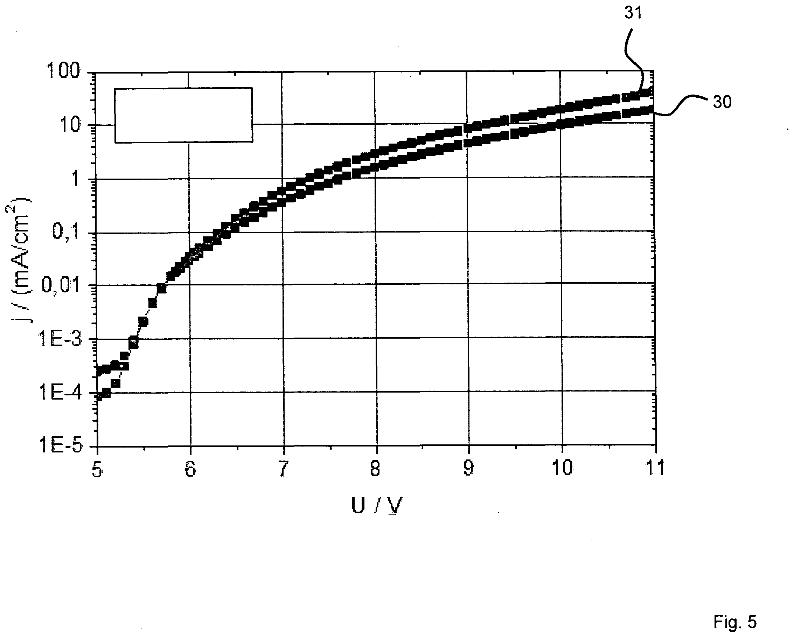

Fig. 3 shows a schematic representation of a further tandem OLED. In the stack of layers 1 provided on the substrate 2 the n-type sublayer 5a of the charge generation layer 5 comprises a first n-type sublayer 5a1 and a second n-type sublayer 5a2. In an alternative embodiment (not shown), the charge generation layer 5 of the tandem OLED in Fig. 5 may comprise the interlayer 16.

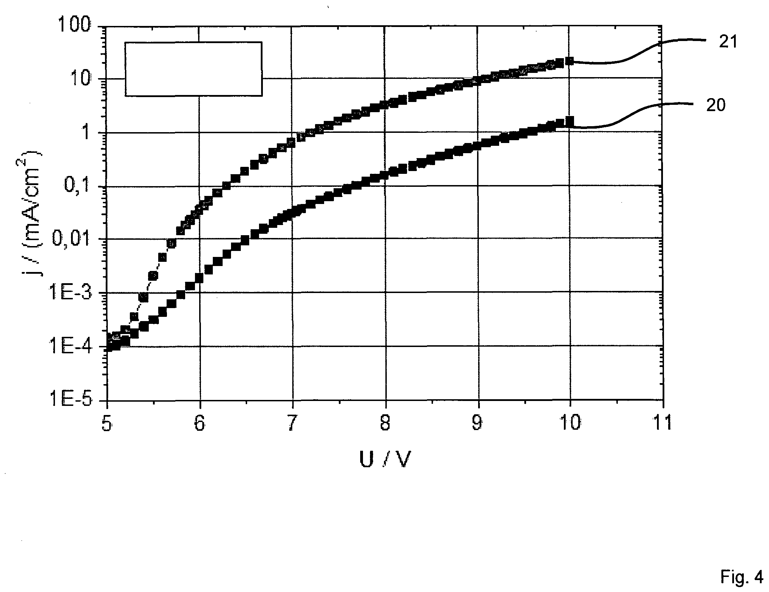

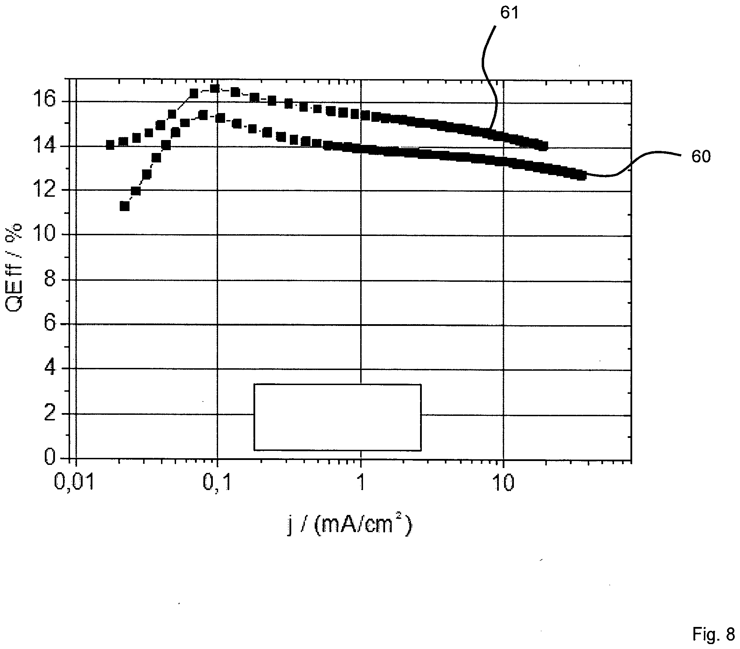

Following, referring to graphical representation in Fig. 4 to 8, alternative embodiments of an organic electronic device provided as a tandem OLED are described which in general, in the examples discussed, are provided with a layer structure as shown in Fig. 1. The performance of the organic electronic devices comprising a p-type sub-layer comprising a fullerene compound comprising 48 fluorine groups, named C₆₀F₄₈ or PD-3, is compared to analogous organic electronic devices comprising state-of-art p-type sublayer comprising quinone compound PD-1.

For the different organic electronic devices, the performance has been studied compared to state of art p-dopants and p-dopants based on fullerenes comprising electron withdrawing groups in an organic electronic device provided as a tandem OLED.

Following, an embodiment of a general procedure for fabrication of organic electronic devices is described.

OLEDs with two emitting layers were prepared to demonstrate the technical benefit of an organic electronic device comprising a charge generation layer according to the present invention. As proof-of-concept, the tandem OLEDs comprised two blue emitting layers.

A 15Ω /cm² glass substrate with 90 nm ITO (available from Corning Co.) was cut to a size of 50 mm x 50 mm x 0.7 mm, ultrasonically cleaned with isopropyl alcohol for 5 minutes and then with pure water for 5 minutes, and cleaned again with UV ozone for 30 minutes, to prepare a first electrode.

The organic layers are deposited sequentially on the ITO layer at 10⁻⁷ mbar, see Table 1 to 3 for compositions and layer thicknesses. In the Tables 1 to 3, c refers to the concentration, and d refers to the layer thickness.

Then, the cathode electrode layer is formed by evaporating aluminum at ultra-high vacuum of 10⁻⁷ mbar and deposing the aluminum layer directly on the organic semiconductor layer. A thermal single co-evaporation of one or several metals is performed with a rate of 0, 1 to 10 nm/s (0.01 to 1 A/s) in order to generate a homogeneous cathode electrode with a thickness of 5 to 1000 nm. The thickness of the cathode electrode layer is 100 nm.

The device is protected from ambient conditions by encapsulation of the device with a glass slide. Thereby, a cavity is formed, which comprises a getter material for further protection.

To assess the performance of the inventive examples compared to the prior art, the current efficiency is measured under ambient conditions (20°C). Current voltage measurements are performed using a Keithley 2400 source meter, and recorded in V.

**Table 1 - Example 1**

| Layer | Layer material | c / [vol%] | d / [nm] |
|---|---|---|---|
| anode | ITO | 100 | 90 |
| first hole injection layer | F1:PD-2 | 92:8 | 10 |
| first hole transport layer | F1 | 100 | 135 |
| first electron blocking layer | F2 | 100 | 10 |
| first emitting layer | ABH113: BD200 | 97:3 | 20 |
| first electron transport layer | F3: LiQ | 50:50 | 25 |
| n-type sub-layer | F4 : Li | 99:1 | 10 |
| interlayer | Metal (Li**) | 100 | 0.5 |
| p-type sub-layer | F1:PD-1 or | 94.5:5.5* | 10 |
| | F1:PD-3 | 80:20 | 10 |
| second hole transport layer | F1 | 100 | 35 |
| second electron blocking layer | F2 | 100 | 10 |
| second emitting layer | ABH113: BD200 | 97:3 | 20 |
| second electron transport layer | F3 : LiQ | 50:50 | 36 |
| cathode | Al | 100 | 100 |

**Table 2 - Example 2**

| Layer | Layer material | c [vol%] | d [nm] |
|---|---|---|---|
| anode | ITO | 100 | 90 |
| first hole injection layer | F1:PD-2 | 92:8 | 10 |
| first hole transport layer | F1 | 100 | 135 |
| first electron blocking layer | F2 | 100 | 10 |
| first emitting layer | ABH113: BD200 | 97:3 | 20 |
| first electron transport layer | F3: LiQ | 50:50 | 25 |
| first n-type sub-layer | F4 : Li | 99:1 | 5 |
| second n-type sub-layer | F4 : Li | from 90:10 to 80:20 | 5 |
| p-type sub-layer | F1:PD-1 or F1:PD-3 | 94.5:5.5* | 10 |
| | | 80:20 | 10 |
| second hole transport layer | F1 | 100 | 35 |
| second electron blocking layer | F2 | 100 | 10 |
| second emitting layer | ABH113: BD200 | 97:3 | 20 |
| second electron transport layer | F3: LiQ | 50:50 | 36 |
| cathode | Al | 100 | 100 |

**Table 3 - Example 3**

| Layer | Layer material | c [vol%] | d [nm] |
|---|---|---|---|
| anode | ITO | 100 | 90 |
| first hole injection layer | F1:PD-2 | 92:8 | 10 |
| first hole transport layer | F1 | 100 | 135 |
| first electron blocking layer | F2 | 100 | 10 |
| first emitting layer | ABH113: BD200 | 97:3 | 20 |
| first electron transport layer | F3 : LiQ | 50:50 | 25 |
| n-type sub-layer | F4 : Yb | 92:8 | 10 |
| p-type sub-layer | F1:PD-1 or | 94.5:5.5* | 10 |
| | F1:PD-3 | 80:20 | 10 |
| second hole transport layer | F1 | 100 | 35 |
| second electron blocking layer | F2 | 100 | 10 |
| second emitting layer | ABH113: BD200 | 97:3 | 20 |
| second electron transport layer | F3 : LiQ | 50:50 | 36 |
| cathode | Al | 100 | 100 |

| | | | |
|---|---|---|---|
| * In the comparative examples, volume ratios matrix:p-dopant in the p-CGL were adjusted so that for both dopants, the molar ratio matrix:p-dopant was equal, having the same value 90:10. ** analogous devices comprising an Yb or Al interlayer afforded very similar results | | | |

Following, auxiliary materials were used in organic electronic devices according to Examples: 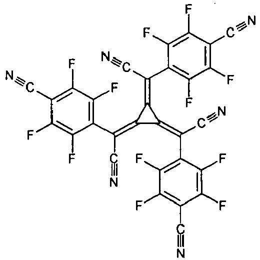
2,2',2"-(cyclopropane-1,2,3-triylidene)-tris[2-(4-cyanoperfluorophenyl)-acetonitrile], CAS1224447-88-4, PD-2; 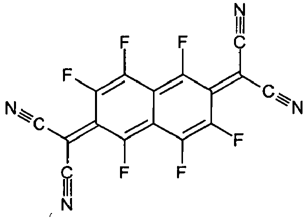
2,2'-(perfluoronaphtalene-2,6-diylidene)dimalononitrile, CAS 912482-15-6, PD-1; 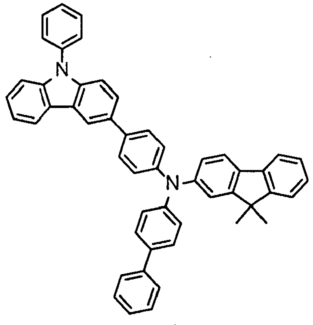
biphenyl-4-yl(9,9-diphenyl-9H-fluoren-2-yl)-[4-(9-phenyl-9H-carbazol-3-yl)phenyl]-amine, CAS 1242056-42-3, F1; 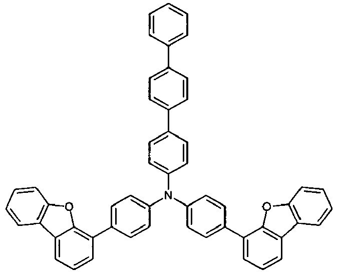
N,N-bis(4-(dibenzo[b,d]furan-4-yl)phenyl)-[1,1':4',1"-terphenyl]-4-amine, CAS 1198399-61-9, F2; 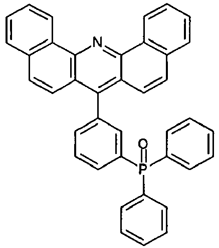 (3-(dibenzo[c,h]acridin-7-yl)phenyl)diphenylphosphine oxide, CAS 1440545-22-1, F3; 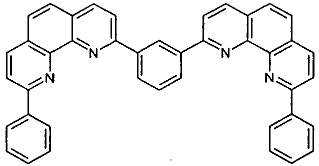 1,3-bis(9-phenyl-1,10-phenanthrolin-2-yl)benzene, CAS 721969-94-4, F4;
lithium 8-hydroxyquinolinolate, CAS 850918-68-2, LiQ.

ABH-113 is an emitter host and BD-200 is a blue fluorescent emitter dopant, both commercially available from SFC, Korea.

Following, technical effects which may be provided by one or more of the alternative embodiments are described.

In Example 1, an interlayer 16 is provided between the n-type sub-layer 5a and the p-type sub-layer 5b of the charge generation layer 5 (see Fig. 2). The interlayer is provided with a layer thickness of about 1 nm. The interlayer is made of Li. The composition and thickness of all layers in example 1 can be taken from Table 1. The performance of the device is shown in Fig. 4. In this case, luminance measurement was made without calibration and quantitative efficiency evaluation was not made. Fig. 4, however, shows a clear operating voltage benefit for fullerene compound PD-3 (curve 21) in comparison to quinone compound PD-1 (curve 20).

With regard to Example 2, the n-type sub-layer 5a consists of two n-type sub-layers 5a1 and 5a2 having different redox n-dopant concentration (see Table 2). Li was used as redox n-dopant. The concentration of Li in the first n-type sublayer 5a1 is lower than the concentration of Li in the second n-type sub-layer 5a2. Thereby, a concentration gradient of Li achieved, whereby the concentration of Li in the n-type sub-layer closer to the first electrode is lower than the concentration of Li in the n-type sub-layer closer to the second electrode. The composition and thickness of all layers in example 2 can be taken from Table 2.

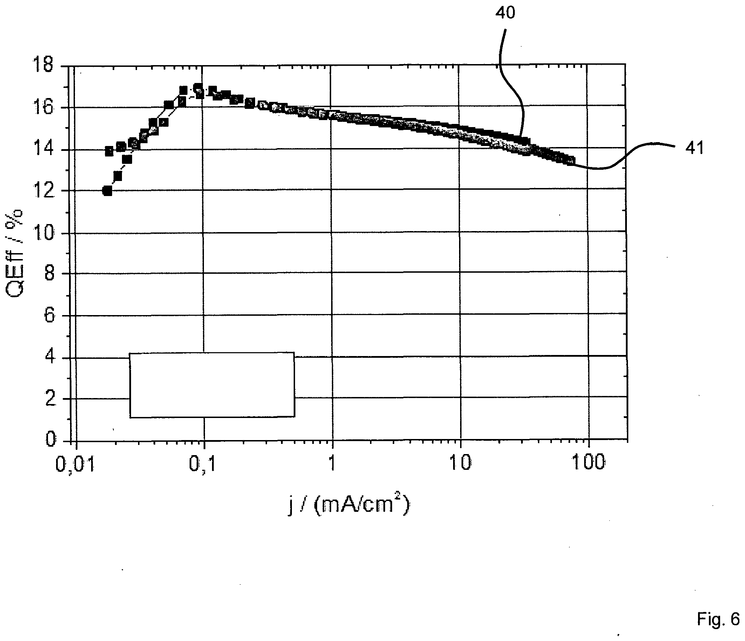

Fig. 5 shows an operating voltage benefit for fullerene compound PD-3 (curve 31) in comparison to quinone compound PD-1 (curve 30). In Fig. 6, the results show comparable quantum efficiency for PD-1 (curve 40) and PD-3 (curve 41).

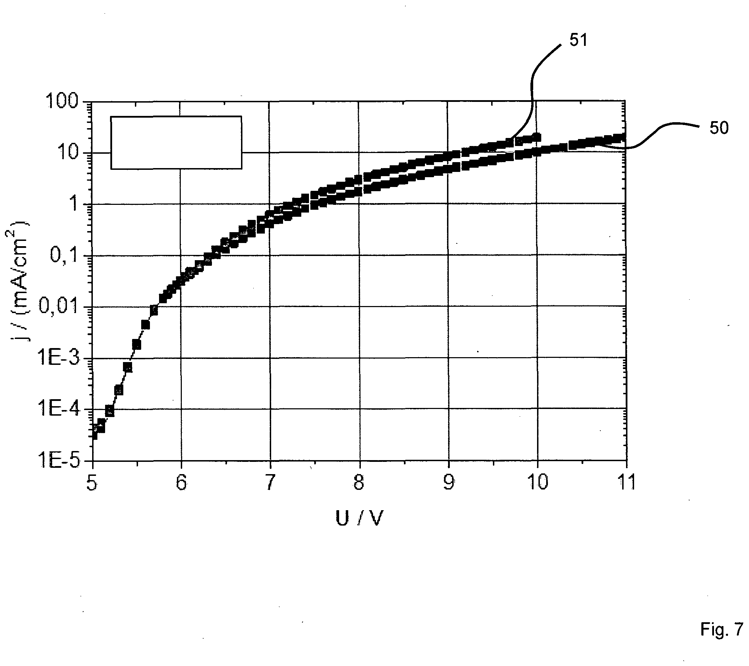

In example 3, the charge generation layer consists of a n-type sub-layer and a p-type sub-layer. The composition and thickness of all layers in example 3 can be taken from Table 3. In Fig. 7, it can be seen that fullerene compound PD-3 offers a benefit in operating voltage over quinone compound PD-1. Moreover, Fig. 6 shows a clear efficiency benefit of the use of fullerene compound PD-3 (curve 61) over the quinone compound PD-1 (curve 60) in this device arrangement.

The features disclosed in this specification, the figures and / or the claims may be material for the realization of various embodiments, taken in isolation or in various combinations thereof.

## Claims

1. An organic electronic device, comprising
- a first electrode (3);
- a second electrode (4); and
- a charge generation layer (5) arranged between the first and the second electrode (3, 4), the charge generation layer (5) comprising
- a n-type sub-layer (5a) comprising at least one redox n-dopant and arranged closer to the first electrode, wherein the n-type sub-layer (5a) comprises at least one electron transport matrix compound, and
- a p-type sub-layer (5b) comprising a fullerene compound dopant and arranged closer to the second electrode, wherein the p-type sub-layer (5b) comprises at least one hole transport matrix compound;
**characterized in that** the fullerene compound comprises at least one electron withdrawing substituent selected from F, Cl, Br, I, CN, halogen-substituted and / or CN-substituted group containing 1 to 20 carbon atoms.

2. The organic electronic device according to claim 1, wherein the at least one redox n-dopant is an elemental metal.

3. The organic electronic device according to claim 1 or 2, wherein the fullerene compound comprises at least two electron withdrawing substituents independently selected from F and CN.

4. The organic electronic device according to at least one of the preceding claims, wherein the fullerene compound has formula CₓF_{y}, wherein x is an integer from 60 to 120 and F is an integer equal or higher than x / 2.

5. The organic electronic device according to at least one of the preceding claims, wherein the at least one hole transport matrix compound is an organic compound.

6. The organic electronic device according to at least one of the preceding claims, wherein the at least one electron transport matrix compound is an organic compound.

7. The organic electronic device according to at least one of the preceding claims, wherein
- the n-type sub-layer (5a) comprises
- a first n-type sub-layer (5a1) arranged closer to the first electrode (3), and
- a second n-type sub-layer (5a2) arranged closer to the second electrode (4), and
- the at least one redox n-dopant is provided with a higher concentration in the second n-type sub-layer (5a2) than in the first n-type sub-layer (5a1).

8. The organic electronic device according to at least one of the preceding claims, wherein an interlayer (16) is provided between the n-type sub-layer (5a), and the p-type sub-layer (5b) in the charge generation layer (5).

9. The organic electronic device according to at least one of the preceding claims, wherein
- the first electrode (3) is provided as an anode;
- the second electrode (4) is provided as a cathode;
- the n-type sub-layer (5a) is arranged closer to the first electrode (3); and
- the p-type sub-layer (5b) is arranged closer to the second electrode (4).

10. The organic electronic device according to claim 9, comprising
- at least one first light emitting layer (9) arranged between the first electrode (3) and the n-type sub-layer (5a), and
- at least one second light emitting layer (14) arranged between the p-type sub-layer (5b) and the second electrode (4).

11. The organic electronic device according to claim 9 or 10, wherein at least one of the at least one first light emitting layer (9) or the at least one second light emitting layer (14) comprises a blue emitter.

12. The organic electronic device according to claim 11, wherein the blue emitter is a blue fluorescent emitter.

13. A method for producing an organic electronic device comprising
- a first electrode (3);
- a second electrode (4); and
- a charge generation layer (5) arranged between the first and the second electrode (3, 4), the charge generation layer (5) comprising
- a n-type sub-layer (5a) comprising at least one redox n-dopant and at least one electron transport matrix compound, and
- a p-type sub-layer (5b) comprising a fullerene compound and at least one hole transport matrix compound;
wherein the fullerene compound comprises at least one electron withdrawing substituent selected from F, Cl, Br, I, CN, halogen-substituted and / or CN-substituted group containing 1 to 20 carbon atoms;
the method further comprising the steps of
- providing a substrate (2) and the first electrode (3),
- depositing a plurality of layers arranged on the first electrode (3), the plurality of layers comprising the charge generation layer (5), and
- depositing the second electrode on the plurality of layers.

14. Method according to claim 13, wherein the depositing of the plurality of layers comprises a step of depositing the p-type sub-layer (5b), the depositing comprising evaporation and deposition of the fullerene compound under reduced pressure.

## Patentansprüche

1. Organische elektronische Vorrichtung, umfassend
- eine erste Elektrode (3);
- eine zweite Elektrode (4); und
- eine Ladungserzeugungsschicht (5), die zwischen der ersten und der zweiten Elektrode (3, 4) angeordnet ist, wobei die Ladungserzeugungsschicht (5) Folgendes umfasst
- eine n-Typ-Unterschicht (5a), die mindestens ein Redox-n-Dotierungsmittel umfasst und näher an der ersten Elektrode angeordnet ist, wobei die n-Typ-Unterschicht (5a) mindestens eine Elektronentransport-Matrixverbindung umfasst, und
- eine p-Typ-Unterschicht (5b), die ein Fulleren-Verbindungs-Dotierungsmittel umfasst und näher an der zweiten Elektrode angeordnet ist, wobei die p-Typ-Unterschicht (5b) mindestens eine Lochtransport-Matrixverbindung umfasst;
**dadurch gekennzeichnet, dass**
die Fulleren-Verbindung mindestens einen elektronentziehenden Substituenten der folgenden umfasst: F, Cl, Br, I, CN, halogen-substituierte und / oder CN-substituierte Gruppe, die 1 bis 20 Kohlenstoffatome enthält.

2. Organische elektronische Vorrichtung nach Anspruch 1, wobei das mindestens eine Redox-n-Dotierungsmittel ein elementares Metall ist.

3. Organische elektronische Vorrichtung nach Anspruch 1 oder 2, wobei die Fulleren-Verbindung mindestens zwei elektronentziehenden Substituenten umfasst, die unabhängig aus F und CN ausgewählt sind.

4. Organische elektronische Vorrichtung nach mindestens einem der vorhergehenden Ansprüche, wobei die Fulleren-Verbindung die Formel CₓF_{y} hat, wobei x eine ganze Zahl von 60 bis 120 ist, und F eine ganze Zahl größer oder gleich x/2 ist.

5. Organische elektronische Vorrichtung nach mindestens einem der vorhergehenden Ansprüche, wobei die mindestens eine Lochtransport-Matrixverbindung eine organische Verbindung ist.

6. Organische elektronische Vorrichtung nach mindestens einem der vorhergehenden Ansprüche, wobei die mindestens eine Elektronentransport-Matrixverbindung eine organische Verbindung ist.

7. Organische elektronische Vorrichtung nach mindestens einem der vorhergehenden Ansprüche, wobei
- die n-Typ-Unterschicht (5a) Folgendes umfasst
- eine erste n-Typ-Unterschicht (5a1), die näher an der ersten Elektrode (3) angeordnet ist, und
- eine zweite n-Typ-Unterschicht (5a2), die näher an der zweiten Elektrode (4) angeordnet ist, und
- das mindestens ein Redox-n-Dotierungsmittel eine höhere Konzentration in der zweiten n-Typ-Unterschicht (5a2) als in der ersten n-Typ-Unterschicht (5a1) aufweist.

8. Organische elektronische Vorrichtung nach mindestens einem der vorhergehenden Ansprüche, wobei eine Zwischenschicht (16) zwischen der n-Typ-Unterschicht (5a) und der p-Typ-Unterschicht (5b) in der Ladungserzeugungsschicht (5) vorgesehen ist.

9. Organische elektronische Vorrichtung nach mindestens einem der vorhergehenden Ansprüche, wobei
- die erste Elektrode (3) als Anode vorgesehen ist;
- die zweite Elektrode (4) als Kathode vorgesehen ist;
- die n-Typ-Unterschicht (5a) ist näher an der ersten Elektrode (3) angeordnet; und
- die p-Typ-Unterschicht (5b) näher an der zweiten Elektrode (4) angeordnet ist.

10. Organische elektronische Vorrichtung nach Anspruch 9, umfassend
- mindestens eine erste lichtemittierende Schicht (9), die zwischen der ersten Elektrode (3) und der n-Typ-Unterschicht (5a) angeordnet ist, und
- mindestens eine zweite lichtemittierende Schicht (14), die zwischen der p-Typ-Unterschicht (5b) und der zweiten Elektrode (4) angeordnet ist.

11. Organische elektronische Vorrichtung nach Anspruch 9 oder 10, wobei mindestens eine der mindestens einen ersten lichtemittierenden Schicht (9) oder der mindestens einen zweiten lichtemittierenden Schicht (14) einen blauen Strahler umfasst.

12. Organische elektronische Vorrichtung nach Anspruch 11, wobei der blaue Strahler ein blauer fluoreszenter Strahler ist.

13. Verfahren zur Herstellung einer organischen elektronischen Vorrichtung, umfassend
- eine erste Elektrode (3);
- eine zweite Elektrode (4); und
- eine Ladungserzeugungsschicht (5), die zwischen der ersten und der zweiten Elektrode (3, 4) angeordnet ist, wobei die Ladungserzeugungsschicht (5) Folgendes umfasst
- eine n-Typ-Unterschicht (5a), die mindestens ein Redox-n-Dotierungsmittel und mindestens eine Elektronentransport-Matrixverbindung umfasst, und
- eine p-Typ-Unterschicht (5b), die eine Fulleren-Verbindung und mindestens eine Lochtransport-Matrixverbindung umfasst;
wobei die Fulleren-Verbindung mindestens einen elektronentziehenden Substituenten der folgenden umfasst: F, Cl, Br, I, CN, halogen-substituierte und / oder CN-substituierte Gruppe, die 1 bis 20 Kohlenstoffatome enthält;
wobei das Verfahren ferner die folgenden Schritte umfasst:
- Bereitstellen eines Substrats (2) und der ersten Elektrode (3),
- Abscheiden einer Vielzahl von Schichten, die auf der ersten Elektrode (3) angeordnet sind, wobei die Vielzahl von Schichten die Ladungserzeugungsschicht (5) umfassen, und
- Abscheiden der zweiten Elektrode auf der Vielzahl von Schichten.

14. Verfahren nach Anspruch 13, wobei das Abscheiden der Vielzahl von Schichten einen Schritt des Abscheidens der p-Typ-Unterschicht (5b) umfasst, wobei das Abscheiden die Verdampfung und Abscheidung der Fulleren-Verbindung bei reduziertem Druck umfasst.

## Revendications

1. Dispositif électronique organique comprenant
- une première électrode (3) ;
- une seconde électrode (4) ; et
- une couche de génération de charge (5) agencée entre la première et la seconde électrode (3, 4), la couche de génération de charge (5) comprenant
- une sous-couche de type n (5a) comprenant au moins un dopant n redox et agencée plus près de la première électrode, dans lequel la sous-couche de type n (5a) comprend au moins un composé de matrice de transport d'électrons, et
- une sous-couche de type p (5b) comprenant un composé de fullerène et agencée plus près de la seconde électrode, dans lequel la sous-couche de type p (5b) comprend au moins un composé de matrice de transport de trou ;
**caractérisé en ce que** le composé de fullerène comprend au moins un substituant attracteur d'électrons choisi parmi F, Cl, Br, I, CN, un groupe substitué par un halogène et / ou substitué par CN contenant de 1 à 20 atomes de carbone.

2. Dispositif électronique organique selon la revendication 1, dans lequel l'au moins un dopant n rédox est un métal élémentaire.

3. Dispositif électronique organique selon la revendication 1 ou la revendication 2, dans lequel le composé de fullerène comprend au moins deux substituants attracteur d'électrons indépendamment choisis parmi F et CN.

4. Dispositif électronique organique selon l'une quelconque des revendications précédentes, dans lequel le composé de fullerène est de formule CₓF_{y}, dans laquelle x représente un nombre entier valant entre 60 et 120 et F représente un nombre entier supérieur ou égal à x/2.

5. Dispositif électronique organique selon l'une quelconque des revendications précédentes, dans lequel l'au moins un composé de matrice de transport de trou est un composé organique.

6. Dispositif électronique organique selon l'une quelconque des revendications précédentes, dans lequel l'au moins un composé de matrice de transport d'électron est un composé organique.

7. Dispositif électronique organique selon l'une quelconque des revendications précédentes, dans lequel
- la sous-couche de type n (5a) comprend
- une première sous-couche de type n (5a1) agencée plus près de la première électrode (3), et
- une seconde sous-couche de type n (5a2) agencée plus près de la seconde électrode (4), et
- l'au moins un dopant n redox est fourni avec une concentration plus élevée dans la seconde sous-couche de type n (5a2) que dans la première sous-couche de type n (5a1).

8. Dispositif électronique organique selon l'une quelconque des revendications précédentes, dans lequel une couche intercalaire (16) est fournie entre la sous-couche de type n (5a) et la sous-couche de type p (5b) dans la couche de génération de charge (5).

9. Dispositif électronique organique selon l'une quelconque des revendications précédentes, dans lequel
- la première électrode (3) est prévue en tant qu'anode ;
- la seconde électrode (4) est prévue en tant que cathode ;
- la sous-couche de type n (5a) est agencée plus près de la première électrode (3) ; et
- la sous-couche de type p (5b) est agencée plus près de la seconde électrode (4).

10. Dispositif électronique organique selon la revendication 9, comprenant
- au moins une première couche d'émission de lumière (9) agencée entre la première électrode (3) et la sous-couche de type n (5a), et
- au moins une seconde couche d'émission de lumière (14) agencée entre la sous-couche de type p (5b) et la seconde électrode (4).

11. Dispositif électronique organique selon la revendication 9 ou la revendication 10, dans lequel au moins une parmi l'au moins une première couche d'émission de lumière (9) ou l'au moins une seconde couche d'émission de lumière (14) comprend un émetteur de lumière bleue.

12. Dispositif électronique organique selon la revendication 11, dans lequel l'émetteur de lumière bleue est un émetteur fluorescent bleu.

13. Procédé de production d'un dispositif électronique organique comprenant
- une première électrode (3) ;
- une seconde électrode (4) ; et
- une couche de génération de charge (5) agencée entre la première et la seconde électrode (3, 4), la couche de génération de charge (5) comprenant
- une sous-couche de type n (5a) comprenant au moins un dopant n redox et au moins un composé de matrice de transport d'électron, et
- une sous-couche de type p (5b) comprenant un composé de fullerène et au moins un composé de matrice de transport de trou ;
dans lequel le composé de fullerène comprend au moins un substituant attracteur d'électrons choisi parmi F, Cl, Br, I, CN, un groupe substitué par un halogène et / ou substitué par CN contenant de 1 à 20 atomes de carbone ;
le procédé comprenant en outre les étapes consistant à
- fournir un substrat (2) et la première électrode (3),
- déposer une pluralité de couches agencées sur la première électrode (3), la pluralité de couches comprenant la couche de génération de charge (5), et
- déposer la seconde électrode sur la pluralité de couches.

14. Procédé selon la revendication 13, dans lequel le dépôt de la pluralité de couches comprend une étape de dépôt de la sous-couche de type p (5b), le dépôt comprenant l'évaporation et le dépôt du composé de fullerène sous une pression réduite.
